# EUROPÄISCHE PATENTANMELDUNG

(11) **EP 0 974 684 A1**
(43) Veröffentlichungstag der Anmeldung: **26.01.2000**
(21) Anmeldenummer: 99113848.8
(22) Anmeldetag: 15.07.1999
(51) Int. Cl.: C23C 28/00, C23C 14/06, C23C 14/02, C23C 14/22

(54) **Mehrlagenschicht und Verfahren zu deren Herstellung**

(30) Priorität: 20.07.1998 DE 19832571
(71) Anmelder: Hauzer Industries B.V., 5916 PA Venlo (NL)
(72) Erfinder: Trinh, T.T., 6291 BP Vaals (NL); Van der Kolk, G.J., 6026 RG Maarheze (NL); Fleischer, W., 5988 KG Helden (NL); Hurkmans, A.P.A., 5862 AE Geysteren (NL)
(74) Vertreter: Manitz, Finsterwald & Partner

(57) **Zusammenfassung**

Es wird eine Mehrlagenhartstoffschicht beschrieben, die aus einem oder mehreren der Metalle Ti, Zr, Hf, Ta, Nb, Cr, Al, Mo und/oder Nitriden, Karbiden, Karbonitriden, Oxiden oder Sulfiden dieser Metalle und/oder deren Legierungen oder Mischphasen und wenigstens einer Schicht mit einem Anteil von mindestens von 5 %-at der Elemente Au oder Ag besteht.

## Beschreibung

Die Erfindung betrifft ein Substrat mit einer nach dem PVD-Verfahren aufgebrachten Mehrlagen-Hartstoffschicht sowie ein Verfahren zur Herstellung einer derartigen Mehrlagenschicht.

Mehrlagen-Hartstoffschichten sind prinzipiell bekannt und haben sich in der Praxis für verschiedenartige Anwendungsfälle bewährt.

Immer wieder problematisch und demgemäß verbesserungsbedürftig ist vor allem die Korrosionsbeständigkeit derartiger Mehrlagenschichten.

Aufgabe der Erfindung ist es daher, Mehrlagen-Hartstoffschichten zu schaffen, die den mit derartigen Schichten versehenen Substraten bzw. Bauteilen hohe Korrosionsbeständigkeit und Abriebfestigkeit verleihen.

Gelöst wird diese Aufgabe nach der Erfindung im wesentlichen durch eine Mehrlagen-Hartstoffschicht, bestehend aus einem oder mehreren der Metalle Ti, Zr, Hf, Ta, Nb, Cr, Al, Mo und/oder Nitriden, Karbiden, Karbonitriden, Oxiden oder Sulfiden dieser Metalle und/oder deren Legierungen oder Mischphasen und wenigstens einer Schicht mit einem Anteil von mindestens von 5 %-at der Elemente Au oder Ag.

Das Schichtsystem gemäß der Erfindung erbringt eine überraschend wirksame Sperrwirkung, die durch werkstoffliche Eigenschaften der verwendeten Metalle sowie die Anwendung eines PVD-Verfahrens bedingt ist, wobei es der spezielle Schichtaufbau mit sich bringt, daß elektrochemische Korrosionsprozesse vermieden bzw. unterbrochen werden und außerdem die Mikroporen der Substratoberflächen und der einzelnen Schichten abgedichtet werden.

Die Au oder Ag enthaltende Sperrschicht kann sowohl unmittelbar auf der Substratoberfläche vorgesehen als auch in den nachfolgenden Mehrlagenschichtaufbau integriert sein und sogar als Topschicht verwendet werden.

Weitere besonders vorteilhafte Ausgestaltungen der Erfindung sowie bevorzugte Verfahrensmerkmale zur Realisierung einer Mehrlagen-Hartstoffschicht gemäß der Erfindung sind in den Unteransprüchen angegeben und werden in der nachfolgenden Beschreibung von Ausführungsbeispielen unter Bezugnahme auf die Zeichnung erläutert; in der Zeichnung zeigt:
- Figur 1: ein Beispiel für den Schichtaufbau einer erfindungsgemäßen Mehrlagen-Hartstoffschicht, und
- Figur 2: eine für die Durchführung des erfindungsgemäßen Verfahrens besonders geeignete Beschichtungsanlage in schematischer Darstellung.

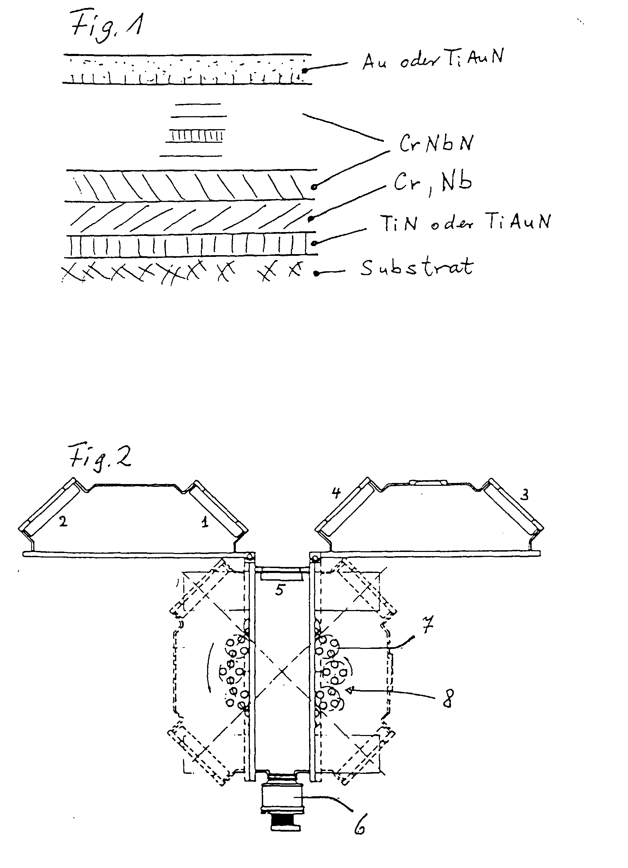

Figur 1 zeigt in schematischer Weise ein Beispiel einer korrosionsbeständigen und verschleißfesten Mehrlagenschicht nach der Erfindung, wie sie für dekorative Gegenstände und auch allgemein für Bauteile verwendbar ist.

Die Mehrlagen-Hartstoffschicht nach der Erfindung ist auf einem Substrat aufgebracht, bei dem es sich um Bauteile oder Gegenstände handeln kann, die aus Kunststoff, Aluminium, Zink, Messing, Kupfer, rostfreien Stählen und dergleichen bestehenden können. In bestimmten Anwendungsfällen, z.B. im Falle von Sanitärarmaturen, kann das jeweilige Substrat auch mit einer oder mehreren galvanisch aufgebrachten Schichten, beispielsweise aus Nickel oder Chrom, vorbehandelt sein, bevor die Mehrlagen-Hartstoffschicht aufgebracht wird.

Bevorzugt wird vor dem Beginn der eigentlichen Beschichtung ein Metallionenätzvorgang mittels kathodischer Bogenentladung durchgeführt, um eine Verankerungszone zu schaffen, worauf dann die Weiterbeschichtung mittels Sputtering und/oder kathodischer Bogenentladung erfolgt.

Für den Metallionenätzvorgang können die Metalle Ti, Zr, Hf, Ta, Nb, Cr, Al, Mo, Cu, Ni, Au, Ag oder deren mehrphasige Kombinationen Verwendung finden.

Im dargestellten Ausführungsbeispiel ist auf das Substrat eine Schicht aus TiN oder TiAuN aufgebracht, wobei im Falle einer TiAuN-Schicht diese Schicht eine Sperrwirkung entfalten kann, die sich hinsichtlich der Korrosionsbeständigkeit vorteilhaft auswirkt.

Auf die an das Substrat anschließende Schicht folgt wenigstens eine Schicht aus Cr, Nb und anschließend eine Mehrzahl von Schichten aus CrNbN. Die Topschicht wird, insbesondere wenn es sich um dekorative Gegenstände handelt, von Au oder TiAuN gebildet, wobei jede der Au enthaltenden Schichten mindestens 5 %-at an Au enthält.

Die Schichtzusammensetzung, die Anzahl der Schichten und die Art der zu verwendenden Topschicht hängt vom jeweiligen Anwendungsfall ab und kann im Rahmen der in den Patentansprüchen angegebenen Möglichkeiten anwendungsbezogen variiert werden.

Figur 2 zeigt eine bevorzugt zur Durchführung des Verfahrens nach der Erfindung verwendbare Beschichtungsanlage.

Diese Anlage ist strichliert im geschlossenen Zustand und mit ausgezogenen Linien mit geöffneten bzw. aufgeschwenkten Kammertüren dargestellt. Im geöffneten Zustand sind die Targets besonders leicht und bequem zugänglich. Die Anlage weist fünf Targets 1, 2, 3, 4, 5 auf, wobei die Targets 1 und 2 in einer aufschwenkbaren Kammerwand und die Targets 3 und 4 in der anderen aufschwenkbaren Kammerwand gehaltert sind. Es handelt sich um Rechteck-Targets, die sich bezogen auf die Zeichnung vertikal erstrecken und wahlweise bevorzugt als kathodische Bogenentladungsverdampfer und als unbalancierte Magnetrons betrieben werden können.

Das bereits angesprochene ABS-Verfahren, das mit dieser Anlage realisierbar ist, wird im einzelnen in der europäischen Patentanmeldung 90 909 697.6 beschrieben.

Die Beschichtungsanlage weist neben einer Turbomolekularpumpe 6 vor allem einen Substratträger 8 auf, der einerseits um eine zentrale Achse rotiert und andererseits Substrathalter aufweist, die wiederum um ihre Achse rotieren, so daß durch den Vorbeilauf der Substrate vor den verschiedenen Targets die jeweils gewünschte Schichtbildung erfolgen kann.

Bei dem ABS-Verfahren werden die Vorteile des kathoden Bogenverdampfungsverfahrens mit denen der Kathodenzerstäubung mit dem unbalancierten Magnetron miteinander verbunden. Bei dem anfänglichen Ätzprozeß im Rahmen einer kathodischen Bogenverdampfung wird nicht nur das zu beschichtende Substrat gereinigt, sondern es wird auch durch Ionenimplantation und Diffusion der jeweiligen Metallkomponente im Substrat eine Verankerungszone im allernächsten Bereich zur Substratoberfläche gebildet, die zu einer wesentlichen Steigerung der Haftfestigkeit zwischen der Mehrlagen-Hartstoffbeschichtung und dem Substrat führt.

Bei der Herstellung des zur Schichtbildung benötigten Metalldampfes werden die in der Beschichtungsanlage vorgesehenen Targets aus den Metallen Ti, Zr, Hf, Ta, Nb, Cr, Al, Mo, Cu, Ni, Au, Ag bzw. daraus gebildeten Legierungen oder Mischphasen verwendet. Als Target für das Aufbringen von Au oder Ag kann ein Target mit 100 %

Reinheitsgrad verwendet werden, aber es ist auch möglich, Targets zu verwenden, die aus einer Legierung von Au oder Ag und den bereits genannten Metallen bestehen, so daß der Au- oder Ag-Anteil vorzugsweise nur im Bereich von 50 % und weniger liegt.

Durch Aktivierung bzw. Zuschaltung der jeweiligen Targets läßt sich die Schichtbildung in der jeweils gewünschten Weise gestalten, und es ist auch problemfrei möglich, den Metallanteil der hergestellten Hartstoffschicht von der Oberfläche des Substrats zur Oberfläche der Beschichtung hin sowohl kontinuierlich als auch in mehrstufiger Weise zu verändern.

Die hergestellten Mehrlagen-Hartstoffschichten zeichnen sich jedoch stets durch hohe Korrosionsbeständigkeit aus und es ist ohne Schwierigkeiten möglich, hohe Abriebfestigkeiten und geringe Schichtrauhigkeiten zu erzielen.

## Patentansprüche

1. Substrat mit einer nach dem PVD-Verfahren aufgebrachten Mehrlagen-Hartstoffschicht, bestehend aus einem oder mehreren der Metalle Ti, Zr, Hf, Ta, Nb, Cr, Al, Mo und/oder Nitriden, Karbiden, Karbonitriden, Oxiden oder Sulfiden dieser Metalle und/oder deren Legierungen oder Mischphasen und wenigstens einer Schicht mit einem Anteil von mindestens von 5 %-at der Elemente Au oder Ag.

2. Substrat nach Anspruch 1,
dadurch **gekennzeichnet,**
daß die einen Anteil von Au oder Ag aufweisende Schicht zwischen der Oberfläche des Substrats und den nachfolgenden Schichten vorgesehen ist.

3. Substrat nach Anspruch 1 oder 2,
dadurch **gekennzeichnet,**
daß wenigstens eine einen Anteil von Au oder Ag aufweisende Schicht zwischen den aufeinanderfolgenden Schichten der Mehrlagenschicht vorgesehen ist.

4. Substrat nach einem oder mehreren der vorhergehenden Ansprüche,
dadurch **gekennzeichnet,**
daß die einen Anteil von Au oder Ag aufweisende Schicht als Topschicht vorgesehen ist.

5. Substrat nach einem oder mehreren der vorhergehenden Ansprüche,
dadurch **gekennzeichnet,**
daß die Mehrlagen-Hartstoffschicht auf einer ein- oder mehrlagigen, auf das Substrat aufgebrachten Galvanoschicht, insbesondere aus Ni oder Cr, vorgesehen ist.

6. Substrat nach einem oder mehreren der vorhergehenden Ansprüche,
dadurch **gekennzeichnet,**
daß als Substratmaterial rostfreie Stähle, Kunststoffe, Aluminium, Zink, Messing oder Kupfer vorgesehen sind.

7. Substrat nach einem oder mehreren der vorhergehenden Ansprüche,
dadurch **gekennzeichnet,**
daß der Metallanteil der Hartstoffschicht ausgehend von der Substratoberfläche zur Topschicht hin in vorgebbarer, insbesondere kontinuierlicher oder mehrstufiger Weise zunimmt.

8. Substrat nach einem oder mehreren der vorhergehenden Ansprüche,
dadurch **gekennzeichnet,**
daß die Schichtdicken der einzelnen Schichten der Mehrlagenschicht zumindest im wesentlichen gleich sind.

9. Verfahren zur Herstellung einer Mehrlagenschicht auf einem Substrat nach einem oder mehreren der vorhergehenden Ansprüche,
dadurch **gekennzeichnet,**
daß die Mehrlagenschicht nach dem ABS-Verfahren, nach einem kombinierten kathodischen Bogenentladungs- und Kathodenzerstäubungsverfahren oder nach dem kathodischen Bogenentladungsaufdampferverfahren auf das Substrat aufgebracht wird.

10. Verfahren nach Anspruch 9,
dadurch **gekennzeichnet,**
daß vor dem Aufbringen einer ersten Teilschicht der Mehrlagenschicht mittels kathodischer Bogenentladung ein Metallionenätzvorgang zur Bildung einer Verankerungsschicht durchgeführt und dabei als Metall Ti, Zr, Hf, Ta, Nb, Cr, Al, Mo, Cu, Ni, Au, Ag oder deren mehrphasige Kombination verwendet wird.

11. Verfahren nach Anspruch 10,
dadurch **gekennzeichnet,**
daß nach dem Metallionenätzvorgang die Mehrschichtbildung mittels Sputtering und/oder einer kathodischen Bogenentladung erfolgt.

12. Verfahren nach einem der Ansprüche 9 bis 11,
dadurch **gekennzeichnet,**
daß zur Mehrschichtbildung in einer Beschichtungsanlage mit zumindest einfach rotierendem Substratträger mehrere um den Substratträger verteilt angeordnete Targets verwendet werden, die aus verschiedenen Metallen, deren Legierungen oder aus Mischphasen bestehen.

13. Verfahren nach einem oder mehreren der Ansprüche 9 bis 12,
dadurch **gekennzeichnet,**
daß die Au oder Ag enthaltende Schicht von einem Target mit einem Au- oder Ag-Anteil von 100 % Reinheitsgrad bis 50 % Reinheitsgrad mit einer Zulegierung des jeweiligen Restanteils aus den Metallen nach Anspruch 10 resultiert.
